# EUROPEAN PATENT APPLICATION

(11) **EP 1 867 464 A1**
(43) Date of publication of application: **19.12.2007**
(21) Application number: 07252356.6
(22) Date of filing: 11.06.2007
(51) Int. Cl.: B29C 70/62, B29C 70/88, B29K 703/06, B29K 301/00

(54) **Composite material sheet and production method thereof**

(30) Priority: 13.06.2006 JP 2006163909
(71) Applicant: NITTO DENKO CORPORATION, Ibaraki-shi, Osaka 567-8680 (JP)
(72) Inventor: Nakatsuka, Yasuo, Nitto Denko Corporation, Ibaraki-shi, Osaka 567-8680 (JP); Kiyohara, Susumu, Nitto Denko Corporation, Ibaraki-shi, Osaka 567-8680 (JP); Tan, Michio, Nitto Denko Corporation, Ibaraki-shi, Osaka 567-8680 (JP); Ikeda, Kenichi, Nitto Denko Corporation, Ibaraki-shi, Osaka 567-8680 (JP); Tanaka, Katsufumi c/o Nat. Univ. Corp. Kyoto Inst. of Techn., Sakyo-ku, Kyoto 606-8585 (JP); Akiyama, Ryuichi c/o Nat. Univ. Corp. Kyoto Inst. of Techn., Sakyo-ku, Kyoto 606-8585 (JP)
(74) Representative: Senior, Alan Murray

(57) **Abstract**

The present invention provides a composite material sheet wherein a filler is oriented in a given direction in an organic resin matrix by an electric field. The composite material sheet of the present invention (10) contains filler (1) and organic resin (3), and is characterized in that the filler (1) is aggregated in the organic resin matrix and oriented in the thickness direction. As a result, properties such as dielectric property, conductivity, thermal conductivity and the like can be strikingly improved as compared to conventional composite materials obtained by simply dispersing a filler.

## Description

The present invention relates to a composite material sheet and a production method thereof. More particularly, the present invention relates to a composite material sheet superior in dielectric property and the like, and useful as electronic or electric parts such as a printed circuit board, a capacitor, a semiconductor sealing resin package and the like and a production method thereof.

Conventionally, composite materials wherein one or more kinds of fillers are dispersed in an organic resin matrix have been used over diversified fields. However, since the composite materials in current use are produced by simply dispersing fillers in organic resin matrix with a ball mill etc., when they are left standing for a long-time, fillers having a greater density than that of the organic resin are precipitated to easily cause inconsistent density, which in turn problematically makes it difficult to obtain a uniform composite material.

To solve such a problem, attempts have been made to orient the fillers in a given direction in the organic resin matrix by utilizing the external field and fix the state of orientation. As the external field, a flow field, a magnetic field, an electric field, an ultrasonic field and the like have been used and, for example, JP-A-2001-185261 proposes an anisotropic conductive sheet wherein conductive ferromagnetic particles are oriented in the thickness direction of the sheet, which is obtained by placing a composite material, wherein conductive ferromagnetic particles are dispersed in an insulating polymer material, between a pair of opposing metal mold magnetic poles, and applying a magnetic field to localize the conductive ferromagnetic particles and cure the insulating polymer material.

However, when a magnetic field whose strength is of an electromagnet level is used, the kind of usable fillers is limited to the ferromagnetic materials of Fe, Ni and Co. While the use of a superconductive magnet affords a strong magnetic field strength permitting use of materials other than the ferromagnetic materials, an apparatus for developing a superconductive magnetic field is expensive and problems in that the area of superconductive magnetic field development is limited to about 100 mm□ and the like occur.

On the other hand, when an electric field is used as an external field, inorganic materials other than the ferromagnetic materials can also be used advantageously. For example, JP-A-2004-193411 proposes a method for producing an electric or electronic component having a high dielectric constant which is obtained by kneading a base polymer and a powder having a high dielectric constant, adding a solvent to give a paste having a controlled viscosity, applying the paste to a conductive substrate to give a thin film and applying an electric field thereto.

However, JP-A-2004-193411 does not report or even suggest that a powder having a high dielectric constant can be oriented in a given direction by application of an electric field to a thin film. Moreover, according to the investigation by the present inventors, it has been found that, when an electric field is applied to a composite material obtained by dissolving an epoxy resin in an organic solvent (MEK), and adding and dispersing barium titanate and the material is heat-cured, according to the method described in JP-A-2004-193411, barium titanate is not oriented and a practical composite material cannot be obtained. In addition, similar results were obtained when an electric field was applied to a coated film obtained by drying the above-mentioned paste to remove the organic solvent. As mentioned above, as the situation stands, there is no established technique for orienting fillers in a given direction in an organic resin matrix by an electric field.

The present invention has been made in view of such situation and aims at providing a composite material sheet wherein fillers are oriented in a given direction in an organic resin matrix by an electric field and a production method thereof.

The present inventors have conducted intensive studies in an attempt to solve the above-mentioned problems and found that a composite material wherein fillers are oriented in a given direction in an organic resin matrix by an electric field cannot be obtained as mentioned above because the organic solvent in the paste evaporates during application of an electric field and heat curing, along with which the composite material is extruded out onto the outer circumference of the electrode. Based on the finding, they have further studied and found that a composite material wherein fillers are oriented in a given direction in an organic resin matrix can be obtained by preparing a composite material wherein fillers are dispersed in an organic resin matrix without using an organic solvent and applying an alternating voltage thereon, which resulted in the completion of the present invention.

Accordingly, the present invention provides the following.
(1) A composite material sheet comprising a filler and an organic resin matrix, wherein the filler is aggregated dendritically and oriented in the thickness direction in the organic resin matrix.
(2) The composite material sheet of the above-mentioned (1), wherein the degree of orientation of the filler is greater than 1.05.
(3) The composite material sheet of the above-mentioned (1) or (2), wherein the filler has a higher dielectric constant than that of the organic resin.
(4) The composite material sheet of any one of the above-mentioned (1) to (3), wherein the filler is at least one kind of an inorganic particle and an inorganic fiber.
(5) The composite material sheet of any one of the above-mentioned (1) to (4), wherein the content of the filler is 5 - 60% by volume relative to the organic resin.
(6) A dielectric sheet comprising the composite material sheet of any one of the above-mentioned (1) to (5) and at least one kind from a dielectric inorganic particle and a dielectric inorganic fiber as the filler.
(7) A thermally conductive sheet comprising the composite material sheet of any one of the above-mentioned (1) to (5) and at least one kind from a thermally conductive inorganic particle and a thermally conductive inorganic fiber as the filler.
(8) An anisotropic conductive sheet comprising the composite material sheet of any one of the above-mentioned (1) to (5) and at least one kind from a conductive inorganic particle and a conductive inorganic fiber as the filler.
(9) A method of producing a composite material sheet wherein a filler is oriented in a given direction in an organic resin matrix, which comprises a kneading step comprising kneading an organic resin and a filler without using an organic solvent to give a composite material having a water content of not more than 0.30 wt%, wherein the filler is dispersed in the organic resin matrix, an electric field treatment step comprising applying the composite material to an electrode, or injecting or placing the composite material between the electrodes, and applying an alternating voltage to orient the filler in a given direction, and a fixing step to fix the oriented filler in the organic resin matrix.
(10) A method of producing a composite material sheet wherein a filler is oriented in a given direction in an organic resin matrix, which comprises a kneading step comprising kneading an organic resin and a filler without using an organic solvent to give a composite material having a water content of not more than 0.30 wt%, wherein the filler is dispersed in the organic resin matrix, an electric field treatment step comprising coating the composite material with a resin film, and applying an alternating voltage to orient the filler in a given direction, and a fixing step to fix the oriented filler in the organic resin matrix.
(11) The production method of the above-mentioned (9) or (10), wherein, in the electric field treatment step, the filler is oriented in the thickness direction as a dendritic aggregate.
(12) The production method of any one of the above-mentioned (9) to (11), wherein the filler has a higher dielectric constant than that of the organic resin.
(13) The production method of any one of the above-mentioned (9) to (12), wherein the filler is at least one kind of an inorganic particle and an inorganic fiber.
(14) The production method of any one of the above-mentioned (9) to (13), wherein, in the kneading step, the composite material is prepared using a filler having an average particle size of not less than 1 µm and an organic resin that makes the ratio (A/B) of the dielectric constant (A) of the filler and the dielectric constant (B) of the organic resin not less than 10 and, in the electric field treatment step, an alternating voltage having an electric field strength of not less than 0.1 kV/mm is applied to the composite material.
(15) The production method of any one of the above-mentioned (9) to (13), wherein, in the kneading step, the composite material is prepared using a filler having an average particle size of not less than 1 µm and an organic resin that makes the ratio (A/B) of the dielectric constant (A) of the filler and the dielectric constant (B) of the organic resin less than 10 and, in the electric field treatment step, an alternating voltage having an electric field strength of not less than 1 kV/mm is applied to the composite material.
(16) The production method of any one of the above-mentioned (9) to (13), wherein, in the kneading step, the composite material is prepared using a filler having an average particle size of less than 1 µm and an organic resin that makes the ratio (A/B) of the dielectric constant (A) of the filler and the dielectric constant (B) of the organic resin not less than 10 and, in the electric field treatment step, an alternating voltage having an electric field strength of not less than 1 kV/mm is applied to the composite material.
(17) The production method of any one of the above-mentioned (9) to (13), wherein, in the kneading step, the composite material is prepared using a filler having an average particle size of less than 1 µm and an organic resin that makes the ratio (A/B) of the dielectric constant (A) of the filler and the dielectric constant (B) of the organic resin less than 10 and, in the electric field treatment step, an alternating voltage having an electric field strength of not less than 10 kV/mm is applied to the composite material.

According to the present invention, a composite material sheet wherein a filler is dendritically aggregated in an organic resin matrix and oriented in the thickness direction can be provided. As a result, the composite material sheet of the present invention is useful in diversified fields including electronic and electric parts such as printed circuit board, capacitor, semiconductor sealing resin package and the like because it can strikingly improve properties such as dielectric property, conductivity, thermal conductivity and the like as compared to conventional composite materials obtained by simply dispersing a filler. In addition, according to the production method of the present invention, since an electric field is used as an external field, various materials can be used as fillers. In addition, since an expensive production apparatus is not particularly necessary, a composite material sheet superior in the dielectric property, conductivity, thermal conductivity and the like can be provided conveniently and at a low cost.
Fig. 1 is a view showing one embodiment of the composite material sheet of the present invention.
Fig. 2 is a view showing another embodiment of the composite material sheet of the present invention.
Fig. 3 is a schematic diagram showing one embodiment of an electric field treatment apparatus used for the production of the composite material sheet of the present invention.
Fig. 4 is a schematic diagram showing another embodiment of the electric field treatment apparatus used for the production of the composite material sheet of the present invention.
Fig. 5 shows a heat pattern in the production of the composite material sheets of the Examples and Comparative Examples.
Fig. 6 shows the relationship between the filler content of the composite material sheet and the dielectric constant.
Fig. 7 is an optical microscopic photograph of the section in the Ia-Ia direction of the composite material sheets obtained in Example 2 and Example 3.
Fig. 8 is an SEM photograph of the section in the Ia-Ia direction of the composite material sheet obtained in Example 4.
Fig. 9 is an SEM photograph of the section in the Ib-Ib direction of the composite material sheet obtained in Example 4.
Fig. 10 is an SEM photograph of the section in the Ia-Ia direction of the composite material sheet obtained in Comparative Example 4.
Fig. 11 is an SEM photograph of the section in the Ib-Ib direction of the composite material sheet obtained in Comparative Example 4.

### [Explanation of symbols]

1: filler, 3: organic resin, 10: composite material sheet

The present invention is explained in detail in the following by referring to preferable embodiments thereof. In the explanation of the drawings, the same element is accorded with the same symbol and duplicate explanations are omitted. For the convenience of showing, the size ratio of the drawings is not necessarily the same as that in the explanation.

### (Composite material sheet)

The composite material sheet of the present invention is characterized in that fillers are aggregated dendritically and oriented in the thickness direction in an organic resin matrix.

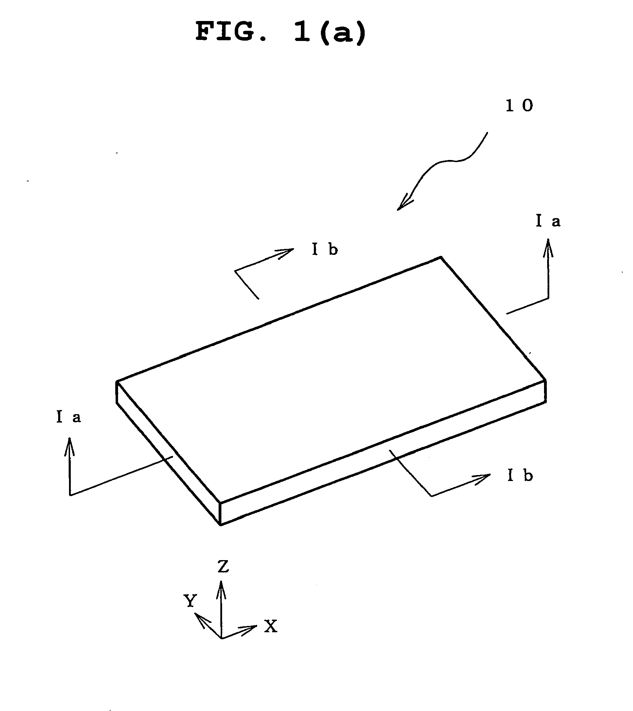

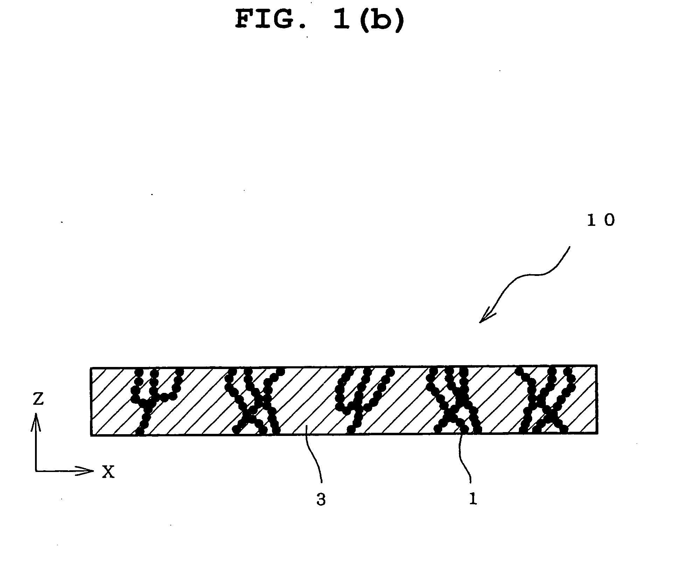

Fig. 1 shows one embodiment of the composite material sheet.

Fig. 1(a) is a perspective view of a composite material sheet 10 and Fig. 1(b) is a schematic sectional view of the composite material sheet 10 along the line Ia-Ia. In the composite material sheet 10 of this embodiment, filler 1 forms a band-like or chain-like aggregate extended in the thickness direction (z axis direction) in an organic resin matrix, and further, aggregates of filler 1 are branched therefrom as the trunk. The terminal portion of the aggregate is exposed on at least one surface of the sheet. That is, the aggregate of the filler 1 forms a dendritic form as a whole, and is oriented in the thickness direction (z axis direction). In addition, a plurality of the aggregate of the filler 1 are present in the organic resin matrix, the adjacent aggregates may be connected to each other and form, for example, a net structure (e.g., honeycomb, ladder).

Thus, in the composite material sheet of this embodiment, since filler aggregates are not only arranged in the thickness direction but also branched, conductive pathway increases and conductive efficiency of electricity and heat can be enhanced as compared to conventional composite materials wherein columnar fillers are oriented in the thickness direction alone. As a result, the dielectric property, conductivity and thermal conductivity of the composite material sheet can be strikingly improved. Hence, the composite material sheet of this embodiment is preferable as an electric or electronic component (e.g., dielectric sheet) requiring high dielectricity such as printed circuit board, capacitor and the like, electric or electronic component (e.g., thermally conductive sheet) requiring high thermal conductivity such as printed circuit board, semiconductor sealing resin package and the like, electric or electronic component (e.g., anisotropic conductive sheet) for electrically and ultrafinely connecting a functional element such as IC and the like and a printed circuit board etc. simultaneously at multipoints, and the like.

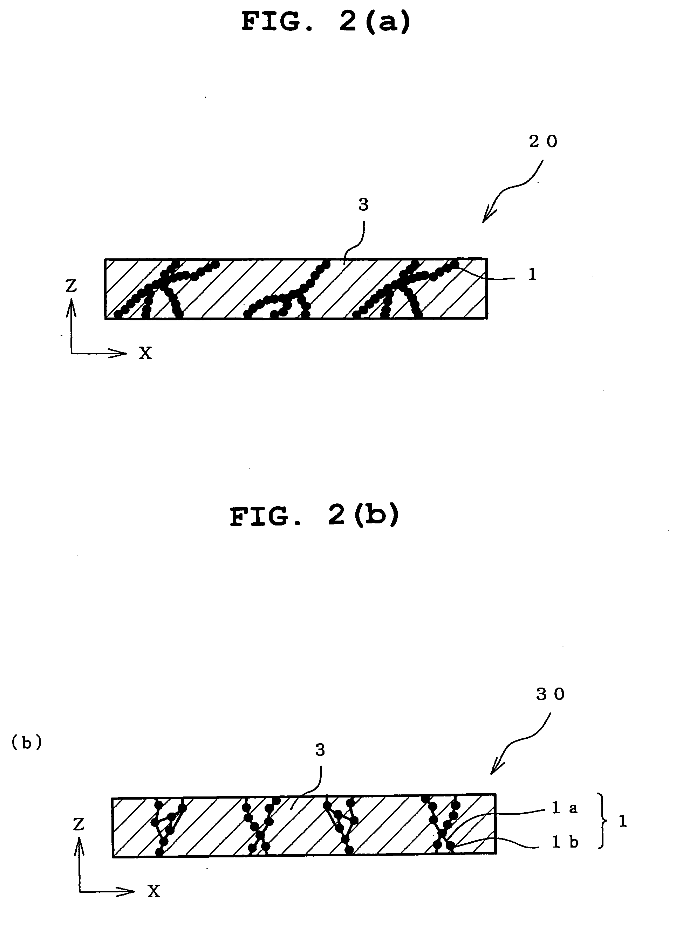

Fig. 2 is a schematic sectional view showing another embodiment of the composite material sheet.

In the composite material sheet 20 shown in Fig. 2(a), the orientation direction is different from a composite material sheet 10 wherein the direction of orientation is the z axis direction since the aggregate constituting the trunk is oriented on a slant relative to the thickness direction (z axis direction), but other constitution is the same as the composite material sheet 10. Therefore, the sheet 20 can have good dielectric property, good conductivity and good thermal conductivity like the composite material sheet 10 and is preferable as a dielectric sheet, a thermally conductive sheet, an anisotropic conductive sheet and the like.

As mentioned above, the filler constituting the composite material sheet of the present invention is oriented in the thickness direction, and the degree of orientation is characteristically greater than 1.05. Here, the degree of orientation refers to the value calculated by the following method. To be specific, an SEM photograph is taken using a scanning electron microscope (SEM, type S-4700, manufactured by Hitachi, Ltd.), and the SEM image of the sheet section is trimmed (512x512 pixel, 25.4 µm×25.4 µm). Then, the image is 2-dimentionally Fourier-transformed using an image treatment soft (ImageJ, manufactured by United States National Institutes of Health), and a profile of a width of about 20% of the whole image (100 pixel width from the center) on average is extracted. Then, the image is fit to the gaussian function (fitting range 30% of the whole, 150 pixel), and the half width C in the longitudinal direction (direction parallel to electric field) and the half width D in the transverse direction (direction perpendicular to electric field) in the fitted function are measured. The D/C ratio is calculated as the degree of orientation. For curve fitting, a graph creating software (IGOR, manufactured by WaveMetrics) is used.

The degree of the orientation of the filler calculated by the above-mentioned method is generally greater than 1.05, preferably not less than 1.1, more preferably not less than 1.2, and further preferably not less than 1.3. By setting such degree of orientation, various properties such as dielectric property, conductivity and thermal conductivity, required in electronic and electric parts such as a printed circuit board, a capacitor, a semiconductor sealing resin package and the like can be strikingly improved.

In addition, the water content of a composite material sheet is preferably not more than 0.30 wt%, more preferably not more than 0.20 wt%, still more preferably not more than 0.10 wt%, particularly preferably not more than 0.05 wt%. By setting such water content, properties such as dielectric property, conductivity, thermal conductivity and the like can be improved further. In the present specification, the water content is measured according to JIS K 0068.

The thickness of the composite material sheet is appropriately determined according to the object of use and is generally 10 - 500 µm, preferably 50 - 200 µm.

The constitution components of the composite material sheet of the present invention are explained in the following.

The organic resin functions as a matrix in the composite material and imparts the composite material with the properties such as processability and flexibility. As the organic resin, one having flowability permitting a filler to move in the organic resin matrix upon application of the electric field is preferably used. That is, when the filler content is low, a desired state of orientation can be obtained even when the organic resin has a relatively high viscosity by moving the filler in the organic resin matrix by the application of an electric field. When the filler content is high, a desired state of orientation cannot be achieved easily unless the viscosity of the organic resin is set to a relatively low level. Thus, the content of the filler and the viscosity of the organic resin are desirably adjusted so that the filler can move easily in the organic resin matrix when an electric field is applied.

As the organic resin, for example, thermoplastic resin, thermosetting resin, photocurable resin, electron beam (EB) curable resin and the like are preferable. In the case of a thermosetting resin and a photocurable resin, a liquid or one having flowability at room temperature is preferably used. While the viscosity of the organic resin varies depending on the property (e.g., content, particle size, shape, surface roughness (surface friction resistance)) of the filler, conditions of electric field application (e.g., frequency of electric field, strength of electric field, application time, temperature) and the like, for example, the viscosity at 25°C is generally 10 - 2,000 mPa·S, preferably 10 - 200 mPa·S. Here, the viscosity is measured using a B type viscosimeter according to JIS 7117-1.

As the thermoplastic resin, polyimide resin, polyamide resin, polyamideimide resin, polyphenyleneoxide, polyphenylenesulfone and the like can be used, with preference given to polyimide resin.

In addition, as the thermosetting resin, epoxy resin, phenol resin, silicone resin, unsaturated polyester resin, bismaleid resin, cyanate resin and the like can be used, with preference given to epoxy resin. As the epoxy resin, a liquid epoxy resin obtained by mixing an aliphatic epoxy resin such as aliphatic polyglycidyl ether and the like as the base resin, and a curing agent (e.g., acid anhydride) and a curing accelerator (e.g., tertiary amine, Lewis acid base type catalyst) is preferably used. The mixing ratio of respective components can be appropriately determined according to the object.

As the photocurable resin, ultraviolet (UV)-curable resin and the like can be used. As the photo or electron beam curable resin, for example, a liquid curable resin made of a mixture of an oligomer such as epoxyacrylate, urethane acrylate and the like, a reactive diluent and a photopolymerization initiator (e.g., benzoin, acetophenone etc.) is preferably used. The mixing ratio of respective components can be appropriately determined according to the object.

The filler is a dispersed to impart the composite material with the properties such as dielectric property, conductivity and thermal conductivity. The filler is not particularly limited as long as it has a higher dielectric constant than that of the matrix resin and, for example, ceramics, metal, alloy and organic resin can be used. The shape of the filler is not particularly limited and, for example, sphere, ellipse, needle, plate, fiber and the like can be used, with preference given to sphere and fiber. They can be used alone or two or more kinds thereof are used in combination.

As the filler, inorganic particle, inorganic fiber, organic resin particle and the like are generally used, with preference given to inorganic particles and inorganic fiber. As the inorganic particles, for example, metal or non-metal carbide, nitride, oxide and the like can be used. Specifically, inorganic powders such as silicon carbide, silicon nitride, boron nitride, aluminum oxide, barium titanate, tin oxide, tin-antimony oxide, titanium oxide/tin-antimony oxide, indium-tin oxide and the like can be used. As the inorganic fiber, for example, ceramics fiber such as barium titanate, alumina, silica, carbon and the like, metal fiber such as iron, copper and the like can be used, with preference given to ceramics fiber such as barium titanate and the like. As the organic resin particles, for example, a powder of polyolefin resin such as polyethylene, polypropylene, polymethylpentene and the like, acrylic resin, polystyrene resin, fluorine resin, silicone resin or a mixture thereof and the like can be used. For example, acrylic resin particles (e.g., crosslinked acrylic particles, non-crosslinked acrylic particles) are commercially available as MX series, MR series and MP series (all of which are trade names of SOKEN CHEMICAL & ENGINEERING CO., LTD.), and polystyrene resin particles (e.g., crosslinked polystyrene particles) are commercially available as SX series and SGP series.

For example, a particle having a two-layer structure (particle with core/shell two-layer structure) wherein a metal particle is used as a core and its outer surface is coated with an inorganic oxide may be used. Specifically, a particle having a two-layer structure wherein a copper particle is used as a core and its outer surface is coated with barium titanate can be used. Moreover, fillers having different shapes can be used in combination. For example, when an inorganic fiber having a diameter of an nm size such as carbon nanotube and a spherical inorganic particle are used in combination, a filler aggregate wherein they are bonded to form a chain can be obtained. Fig. 2(b) is a schematic sectional view of a composite material sheet 30 wherein filler 1 is a combination of an inorganic fiber la and an inorganic particles 1b. By such a constitution, superior dielectric property, conductivity and thermal conductivity can be expressed with a smaller filler content.

When an inorganic particle or organic resin particle is used as a filler, one having an about uniform particle size and without dispersion in the particle size distribution is preferably used. The average particle size of the filler is generally 0.5 nm - 100 µm, preferably 10 nm - 20 µm, more preferably 100 nm - 10 µm. When the particle size is less than 0.5 nm, the response to the electric field tends to be degraded due to the Brownian motion of the filler. On the other hand, when it exceeds 100 µm, a desired state of orientation cannot be obtained easily because the filler tends to precipitate due to the gravity.

In the present specification, the average particle size means an average particle size (D50) obtained by measuring the filler to be used with a laser diffraction particle size distribution measurement apparatus (type LA-920, manufactured by Horiba, Ltd.). When the average particle size is 0.1 µm or below, it means an average particle size (D50) obtained by measuring with a dynamic light scattering particle size distribution analyzer (type N5, manufactured by Beckman Coulter, Inc.).

In addition, as the inorganic fiber, one having a fiber diameter of generally 1 nm - 10 µm, preferably 10 nm - 1 µm, a fiber length of generally 10 nm - 100 µm, preferably 0.1 - 100 µm, and its aspect ratio of generally not less than 10, preferably not less than 100 is used.

The content of the filler is preferably 5 - 60% by volume, more preferably 10 - 40% by volume, still more preferably 20 - 30% by volume, relative to the organic resin constituting the matrix. When it is less than 5% by volume, since the filler is oriented successively rather than continuously when the electric field is applied, a desired state of orientation cannot be obtained easily. On the other hand, when it exceeds 60% by volume, the composite material cannot be prepared easily, and the processability and flexibility of the sheet tends to decrease.

In addition, the composite material sheet of the present invention can afford an electronic or electric product suitable for the object because a filler having desired properties is contained.

For example, at least one kind from a dielectric inorganic particle and a dielectric inorganic fiber is used as a filler, and it is oriented in a given direction in the organic resin matrix, for example, a dielectric sheet having a high dielectric constant of not less than 10 can be obtained. While the dielectric inorganic particles and dielectric inorganic fiber are not particularly limited as long as they are inorganic materials having dielectric property, for example, barium titanate, zinc magnesium niobate titanate, strontium titanate and the like are used, with preference given to barium titanate. As the dielectric sheet, for example, a condenser sheet having a high dielectric constant or a capacitor sheet having a high dielectric constant can be used. In the present specification, the dielectric constant is measured according to JIS K 6911.

Moreover, using at least one kind from a thermally conductive inorganic particle and a thermally conductive inorganic fiber as a filler, for example, a thermally conductive sheet having a high thermal conductivity of not less than 2 W/m·k can be obtained. While the thermally conductive inorganic particle and thermally conductive inorganic fiber are not particularly limited as long as they are inorganic materials having thermal conductivity, for example, beryllia, aluminum nitride, boron nitride, silicon carbide, alumina, magnesia, titania and the like are used, with preference given to boron nitride. In the present specification, thermal conductivity is measured according to ASTM E1530.

Moreover, using at least one kind of a conductive inorganic particle and a conductive inorganic fiber as a filler, for example, an anisotropic conductive sheet having superior conductivity as evidenced by a volume resistivity of not more than 1x10⁴ Ω·cm can be obtained. The conductive inorganic particles and conductive inorganic fiber are not particularly limited as long as they are inorganic materials having conductivity, for example, gold plated nickel particles, silver particles, gold particles, gold plated polymer particles and the like are used, with preference given to gold plated nickel particle. In the present specification, the volume resistivity is measured according to JIS K 7194.

The composite material sheet of the present invention has been explained in detail in the above by referring to the embodiments, which are not to be construed as limitative. Various modifications and changes may be made to the present invention without departing from the scope of the invention. The composite material sheet can contain additives according to the object of use, such as antioxidant, thermal stabilizer, light stabilizer, UV absorber, lubricant, antifogging agent, antiblocking agent, colorant, flame-retardant, antistatic agent, conductivity imparting agent and the like, and their proportions can be determined appropriately. In addition, the composite material sheet may be processed according to the object of use. In the case of a dielectric sheet, for example, an electrode plate may be removed by wet etching and a new electrode may be formed.

### (Production method of composite material sheet)

The production method of the composite material sheet of the present invention is characterized in that it includes a kneading step, an electric field treatment step and a fixing step. Each step is explained in detail in the following.

First, an organic resin and a filler are prepared.

Whether or not the filler is oriented in a given direction in the organic resin matrix is influenced by the content of the conductive component in the composite material. Therefore, the content of the conductive component in the composite material is desirably as small as possible. As the conductive component, water and ion components such as halogen ion, metal ion and the like can be mentioned, and an influence of water is particularly high.

From such aspect, in the present invention, the water content of the composite material is set to not more than 0.30 wt%, preferably not more than 0.20 wt%, more preferably not more than 0.10 wt%, further preferably not more than 0.05 wt%. To achieve a composite material having such water content, the following materials are preferably used as the organic resin and the filler. The water content of the composite material here means the water content of the composite material immediately before application of an electric field, and is measured according to JIS K 0068 as mentioned above.

As the organic resin, one having a water content of preferably not more than 0.1 wt%, more preferably not more than 0.05 wt%, is used. To achieve such water content, the organic resin is desirably dried or preserved in a desiccator. In this case, the inside of the desiccator is desirably made an argon atmosphere.

As the filler, one having a water content of preferably not more than 0.1 wt%, more preferably not more than 0.05 wt%, is used. To achieve such water content, the filler only needs to be dried by heating, and the conditions of drying by heating are, for example, 150 - 350°C/1 - 10 hr, preferably 200 - 300°C/2 - 3 hr. When the water content is outside the above-mentioned ranges, the filler violently moves in the organic resin matrix during application of an electric field, making it difficult to afford a desired state of orientation. The water content is measured according to JIS K 0068 as mentioned above.

Then, a kneading step is performed. In the kneading step, an organic resin and a filler are kneaded without using an organic solvent to give a composite material having a water content of not more than 0.30 wt%, wherein the filler is dispersed in the organic resin matrix. In the present invention, since an organic solvent is not used during preparation of the composite material, an organic resin which is liquid at room temperature or an organic resin that becomes flowable by heating is used as the organic resin. The amount of the filler to be used is preferably 5 - 60% by volume, more preferably 10 - 40% by volume, still more preferably 20 - 30% by volume, relative to the organic resin.

A method for dispersing a filler in an organic resin matrix is not particularly limited, and a known dispersion means such as ball mill, disperse mix, kneader and the like can be used according to the viscosity of the organic resin. When the filler forms a massive aggregate before application of an electric field, orientation in a given direction becomes difficult in the below-mentioned electric field treatment step. Thus, it is desirable to perform a sufficient dispersing treatment.

Then, an electric field treatment step is performed. In the electric field treatment step, to orient the filler in a given direction, an alternating voltage is applied to the composite material obtained in the kneading step.

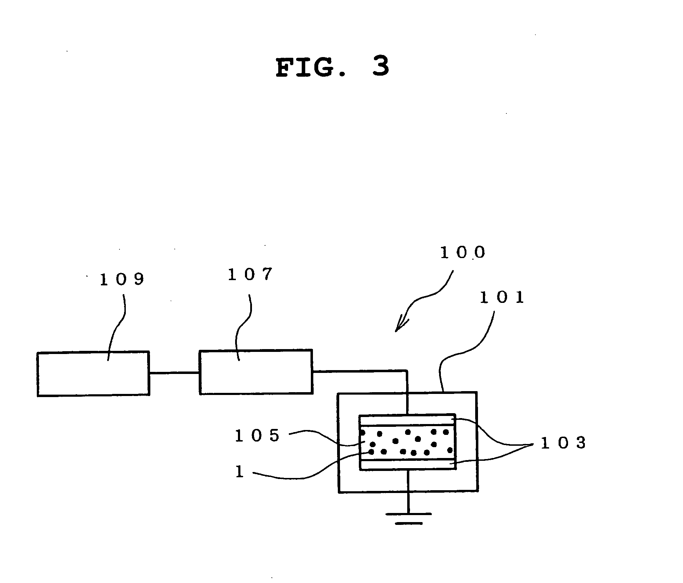

Fig. 3 is a schematic diagram showing one embodiment of an electric field treatment apparatus used for the production of the composite material sheet of the present invention. In an electric field treatment apparatus 100, a pair of opposing electrodes 103 are set in a chamber 101, and a composite material 105 is placed between electrodes 103. The electrode 103 is, for example, a conductive substrate wherein copper foil is attached onto a SUS support via a conductive two-sided tape. The electrode 103 is connected to an amplifying device 107 and a voltage generator 109, which enables application of an electric field to the composite material 105 under desired conditions.

To prepare a sheet-like composite material to be placed between electrodes when the matrix resin is a thermosetting resin or photocurable resin which is liquid at room temperature, for example, the composite material is injected between the electrodes or the composite material is applied to one of the electrodes to give a coated film. When the matrix resin is a thermoplastic resin which is solid at room temperature, for example, the composite material is kneaded in an extruder, and the composite material is processed into a sheet by extrusion forming and the like, and placed between electrodes. The thickness of the sheet-like composite material is generally 10 - 500 µm, preferably 50 - 200 µm.

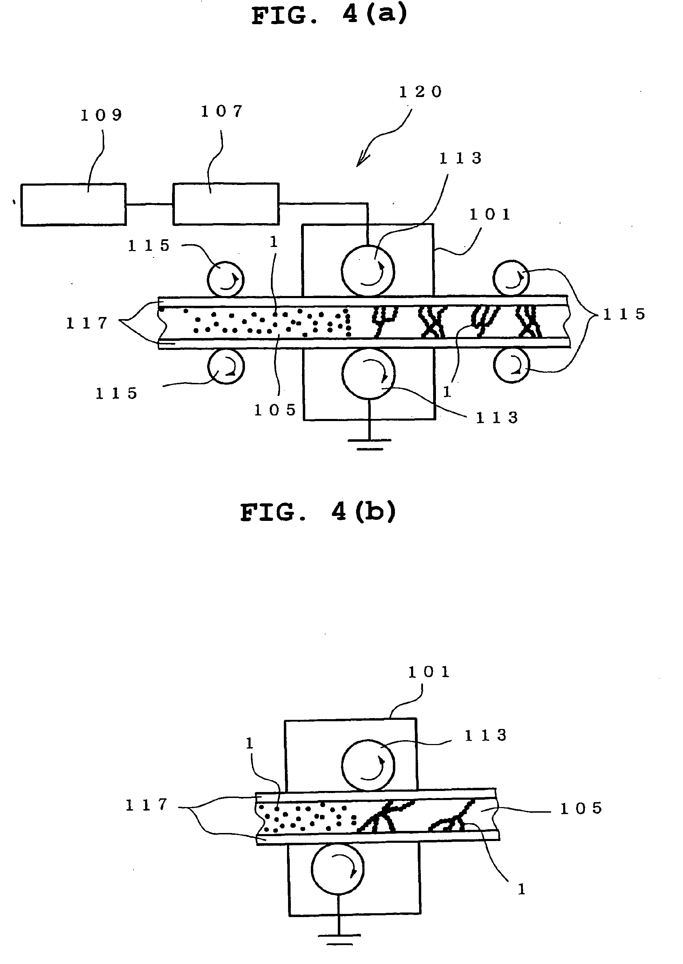

Fig. 4 is a schematic diagram showing another embodiment of the electric field treatment apparatus. In an electric field treatment apparatus 120, roll-like electrodes 113 are set in a chamber 101, and a feeding part 115 for feeding the composite material 105 is set therein, on which points its constitution is different from that of the electric field treatment apparatus 100. The electrode 113 is, for example, a conductive roll made of a conductive metal (e.g., copper alloy, iron alloy). The surface of the composite material 105 is covered with a resin film 117.

To prepare a composite material with the surface coated with a resin film when the matrix resin is a thermosetting resin or photocurable resin which is liquid at room temperature, for example, the composite material is applied to the resin film to form a coated film, and then the resin film is placed on the coated film. When the matrix resin is a thermoplastic resin which is solid at room temperature, for example, the composite material and the resin film are laminated by coextrusion to give a sheet-like composite material. The thickness of the composite material is as mentioned above. As the resin film, polyolefin film (e.g., polyethylene film, polypropylene film), polyester film (e.g., polyethylene terephthalate film) and the like are preferably used, and its thickness is generally 5 - 50 µm, preferably 10 - 25 µm.

To orient the filler in the organic resin matrix in a given direction, an electric field is applied to the obtained sheet-like composite material. Where necessary, heating may be applied during application of the electric field. When the electric field is applied, the filler is aligned in aggregates in the direction of application of the electric field to form a trunk of branches. In addition, branches extending from the trunk in the direction of application of the electric field are formed. As a result, the end of the branches or trunk comes into contact with at least one of the electrodes. Using, for example, the electric field treatment apparatuses shown in Fig. 3 and Fig. 4(a), the filler can be oriented as shown in Fig. 1. In addition, it is possible to orient the filler as shown in Fig. 2(a) by moving one of the electrodes in the chamber to the downstream of the other electrode, as shown in Fig. 4(b). Using the electric field treatment apparatus shown in Fig. 4(a) and (b), the composite material with its surface covered with a resin film can be continuously treated with an electric field. As a result, the production yield of the composite material sheet is strikingly improved.

In the present invention, an alternating voltage is used as the electric field under the following treatment conditions. Moreover, the present inventors have found that the filler moves violently in the organic resin matrix upon application of a direct voltage, which prevents orientation of the filler.

The electric field strength is generally 0.1 - 50 kV/mm, preferably 1 - 25 kV/mm, more preferably 3 - 20 kV/mm. When it is less than 0.1 kV/mm, the Brownian motion of the filler becomes dominant and a desired state of orientation cannot be obtained easily. When it exceeds 50 kV/mm, the composite material tends to show a dielectric breakdown.

The frequency is generally 0.1 - 1 MHz, preferably 0.1 - 100 kHz, more preferably 0.1 - 50 kHz, still more preferably 0.1 - 20 kHz. When the frequency is outside the above-mentioned range, a desired dispersion state cannot be obtained easily.

While the treatment time is not the same for the various matrix resins to be used, it is generally 0.01 - 2 hr, preferably 0.01 - 1 hr, more preferably 0.01 - 0.1 hr. When it is less than 0.01 hr, the orientation of the filler sometimes becomes insufficient and, when it exceeds 2 hr, the composite material tends to show a dielectric breakdown.

The electric field treatment is particularly preferably performed under the conditions shown in Table 1 in consideration of the average particle size of the filler, the dielectric constants of the filler and organic resin and the like.

**Table 1**

| average particle size (µm) of filler | ratio (A/B) of dielectric constant (A) of filler and dielectric constant (B) of organic resin | electric field strength (kV/mm) | frequency (kHz) |
|---|---|---|---|
| ≥1 | ≥10 | ≥0.1 (preferably 0.1 - 10) | ≥0.1 |
| | <10 | ≥1 (preferably 1 - 20) | ≥0.1 |
| <1 | ≥10 | ≥1 (preferably 1 - 50) | ≥0.1 |
| | <10 | ≥10 (preferably 10 - 50) | ≥0.1 |

Then, a fixing step is performed. In the fixing step, filler aggregates oriented in a given direction in the electric field treatment step are fixed in the organic resin matrix while maintaining the state of orientation. In the present invention, matrix resin can be selected according to the object of use. The matrix resin includes photocurable resin that is instantaneously cured to permit easy fixing of the oriented filler in the organic resin matrix, and thermoplastic resin and thermosetting resin that cannot fix the filler in an oriented state in the organic resin matrix until they are solidified or cured, thus requiring continuous application of an electric field. Therefore, the electric field may be applied continuously in the fixing step.

A method for fixing a filler when the matrix resin is a thermosetting resin is, for example, a method including heating for curing. While the curing conditions are appropriately set according to the organic resin to be used, the curing temperature is generally 100 - 200°C, preferably 120 - 180°C, and the curing time is generally 1 - 10 hr, preferably 2 - 5 hr.

When the matrix resin is a photocurable resin, for example, a method for curing by irradiation of UV and the like can be employed. In this case, photoirradiation may be performed simultaneously with the application of an electric field, and a substrate superior in light permeability (e.g., ITO) can be used as an electrode. While the irradiation conditions can be appropriately set according to the organic resin to be used, the irradiation strength is generally not less than 200 mW/cm², and the irradiation time is generally 1 - 10 min, preferably 3 - 5 min. It is desirable to appropriately select the irradiation strength and the irradiation time to achieve not less than 2500 mJ/cm².

Moreover, when the matrix resin is a thermoplastic resin, for example, a method including cooling for solidification can be used.

According to the production method of the present invention, since an electric field is used as the external field, a filler can be oriented in a desired direction in the organic resin matrix without being limited by the properties of the filler to be used. In addition, the production method of the present invention does not require a special and expensive production apparatus. Therefore, a desired composite material sheet can be produced conveniently and at a low cost.

The present invention is explained in more detail in the following by referring to Examples, which are not to be construed as limitative.

### [Examples]

### (Examples 1 - 5)

Non-solvent type epoxy resins were prepared by adding each component described in the following Table 2. The dielectric constant of the obtained non-solvent type epoxy resins was 3.3.

**Table 2**

| | Distributor | Model number | Classification | Amount added |
|---|---|---|---|---|
| main agent | Tohto kasei Co., Ltd. | ZX-1658 | aliphatic | 100 parts by weight |
| curing agent | Japan Epoxy Resins Co., Ltd. | YH306 | acid anhydride | 160 parts by weight |
| curing accelerator | PTI Japan Ltd. | K-61B | Tertiary amine, Lewis base type catalyst | 3 parts by weight |

To each of the obtained non-solvent type epoxy resins was added barium titanate (BaTiO₃) powder (5, 10, 20 or 30 vol%, BT-03, manufactured by Sakai Chemical Industry Co., Ltd., average particle size 0.3 µm, purity not less than 99.9%, dielectric constant about 3,300), and composite materials were prepared by a dispersion treatment using a planetary ball mill (model number Planet-M, manufactured by Gokin Planetaring).

The container and ball used for the dispersion treatment were made of zirconia, and balls having a diameter of 1, 2, 4 or 8 mm were used in combination. The treatment conditions were number of revolution 600 rpm, number of rotation 1,500 rpm and treatment time 10 min. The water content of each composite material was 0.03 wt%.

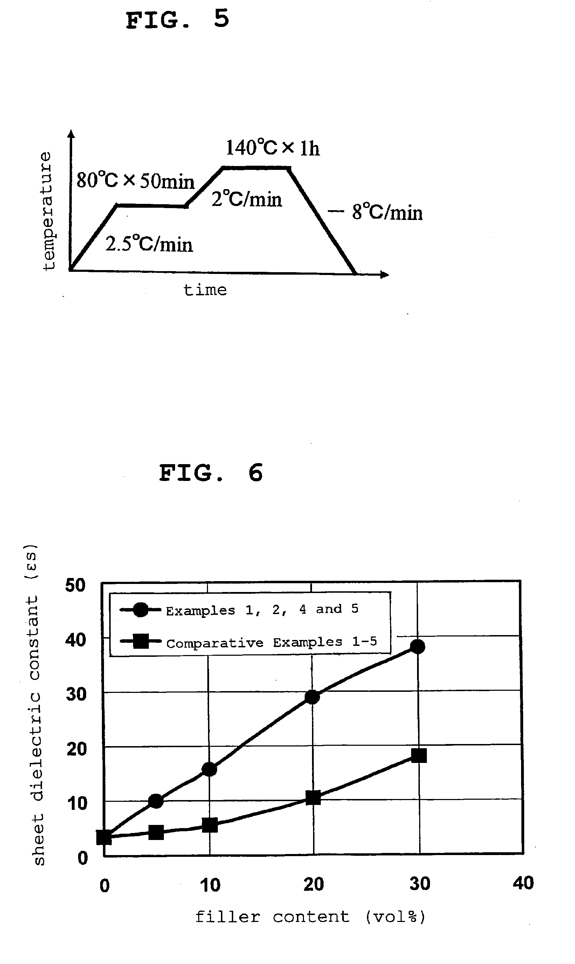

Then, a dynamic viscoelastic apparatus (MR-300V, manufactured by Rheology Co., Ltd.) was modified to give an electric field treatment apparatus, and an upper electrode (1 oz copper foil) and a lower electrode (3 oz copper foil), in each of which a copper foil was attached to a SUS support via a conductive two-sided tape, were mounted thereon. Thereafter, a composite material was injected between the electrodes and the gap amount was adjusted to 50 - 100 µm thick. Then, the composite material was heated in the heat pattern shown in Fig. 5 simultaneously with the start of electric field application. The electric field treatment conditions are as shown in Table 3.

After cooling, the SUS supports were taken out from the electric field treatment apparatus, and repeatedly immersed in liquid nitrogen and stood in the air. The conductive two-sided tapes on the SUS supports were separated from the copper foils to give composite material sheets with copper foils. The water content of each composite material sheet was 0.03 wt%.

**Table 3**

| | BaTiO₃ content | electric field treatment conditions | | |
|---|---|---|---|---|
| | | waveform of power source | frequency | electric field strength |
| Example 1 | 5 vol%. | alternating current | 10 kHz | 16 kV/mm |
| Example 2 | 10 vol% | alternating current | 10 kHz | 16 kV/mm |
| Example 3 | 20 vol% | alternating current | 10 kHz | 8 kV/mm |
| Example 4 | 20 vol% | alternating current | 10 kHz | 16 kV/mm |
| Example 5 | 30 vol% | alternating current | 10 kHz | 16 kV/mm |

### (Example 6)

To a non-solvent type epoxy resin obtained by adding each component described in Table 2 was added a boron nitride powder (20 vol%, model number UHP-1, hexagonal boron nitride, manufactured by Showa Denko K.K., average particle size 9.3 µm, dielectric constant about 4.5), and a composite material was obtained in the same manner as in Example 1. The water content of the composite material was 0.03 wt%.

Then, in the same manner as in Example 1, the composite material was heated in the heat pattern shown in Fig. 5, and an alternating voltage was applied at frequency 0.1 kHz, electric field strength 3 kV/mm to give a composite material sheet with a thickness of 100 µm. The water content of the composite material sheet was 0.03 wt%.

### (Example 7)

To a non-solvent type epoxy resin obtained by adding each component described in Table 2 was added gold-plated nickel particles (10 vol%, manufactured by FUKUDA MTEAL FOIL & POWDER CO., LTD., average particle size 7.4 µm, thickness of gold plating 0.1 - 0.15 µm), and a composite material was obtained in the same manner as in Example 1. The water content of the composite material was 0.03 wt%.

Then, in the same manner as in Example 1, the composite material was heated in the heat pattern shown in Fig. 5, and an alternating voltage was applied at frequency 10 kHz, electric field strength 16 kV/mm to give a composite material sheet with a thickness of 100 µm. The water content of the composite material sheet was 0.03 wt%.

### (Comparative Example 1)

In the same manner as in Example 1 except that a barium titanate powder was not added to the non-solvent type epoxy resin, a composite material sheet was obtained. The content of the BaTiO₃ powder in the composite material sheet is as shown in Table 4.

### (Comparative Examples 2 - 5)

In the same manner as in Examples 1 - 3 and 5 except that the electric field treatment was not performed, composite material sheets were obtained. The content of the BaTiO₃ powder in the composite material sheets is as shown in Table 4.

**Table 4**

| | BaTiO₃ content |
|---|---|
| Comparative Example 1 | 0 vol% |
| Comparative Example 2 | 5 vol% |
| Comparative Example 3 | 10 vol% |
| Comparative Example 4 | 20 vol% |
| Comparative Example 5 | 30 vol% |

### (Comparative Example 6)

In the same manner as in Example 6 except that the electric field treatment was not performed, a composite material sheet was obtained.

### (Comparative Example 7)

In the same manner as in Example 7 except that the electric field treatment was not performed, a composite material sheet was obtained.

### (Comparative Example 8)

In the same manner as in Example 1 except that a composite material having the same composition as Example 1 and a water content of 0.36 wt% was used, a composite material sheet was obtained.

### (Comparative Example 9)

In the same manner as in Example 2 except that a composite material having the same composition as Example 2 and a water content of 0.36 wt% was used, a composite material sheet was obtained.

### (Comparative Example 10)

In the same manner as in Example 4 except that a composite material having the same composition as Example 4 and a water content of 0.36 wt% was used, a composite material sheet was obtained.

### (Comparative Example 11)

In the same manner as in Example 5 except that a composite material having the same composition as Example 5 and a water content of 0.36 wt% was used, a composite material sheet was obtained.

### (Evaluation tests)

### (1) Dielectric property

The 1 oz copper foil of the upper electrode was removed from the composite material sheets with copper foils obtained in Examples 1 - 5 and Comparative Examples 1 - 5 and 8 - 11, gold was vapor deposited on the copper foil removal surface to form a thin film main electrode, whereby evaluation samples were prepared. Using an impedance/gain-phase-analyzer (model HP4194A, manufactured by Yokogawa-Hewlett-Packard), and an electrode exclusively for the dielectric property measurement (model HP16451B), the dielectric constant and dielectric tangent were measured at 1 kHz. The measurement results are shown in Table 5. The relationship between the filler content of the composite material sheet and dielectric constant is shown in Fig. 6.

### (2) Degree of orientation

SEM photographs of the composite material sheets obtained in Examples 1 - 7, and Comparative Examples 2 - 5 and 8 - 11 were taken using a scanning electron microscope (SEM, model S-4700, manufactured by Hitachi, Ltd.), and the SEM images on the sheet section were trimmed (512×512 pixel, 25.4 µm×25.4 µm). Using an image processing soft (ImageJ, United States National Institutes of Health), the images were 2-dimentionally Fourier-transformed, and a profile of a width of about 20% of the whole image (100 pixel width from the center) on average is extracted. Then, the image was fit to the gaussian function (fitting range 30% of the whole, 150 pixel), and the half width C in the longitudinal direction (direction parallel to electric field) and the half width D in the transverse direction (direction perpendicular to electric field) in the fitted function were measured. The D/C ratio was calculated as the degree of orientation. The measurement results are shown in Table 5. For the curve fitting, a graph creating software (IGOR, manufactured by Wave Metrics) was used.

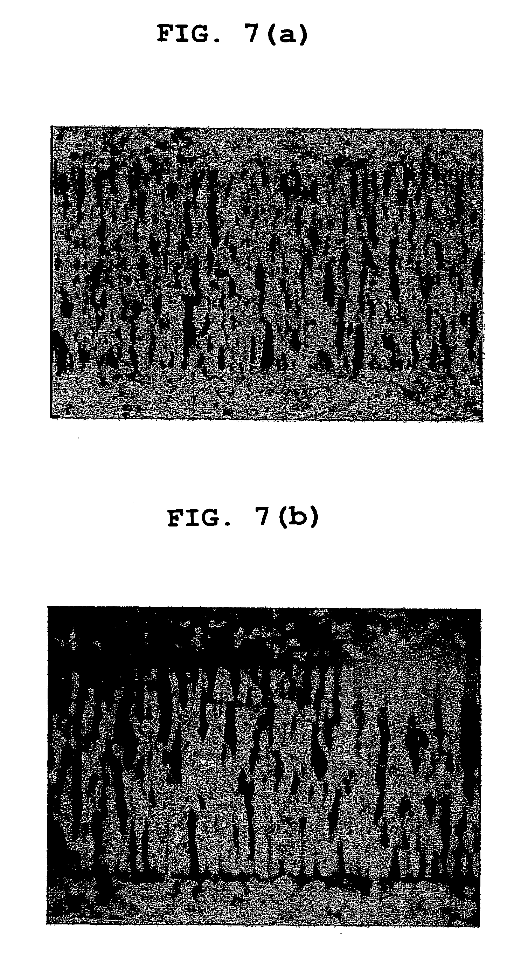

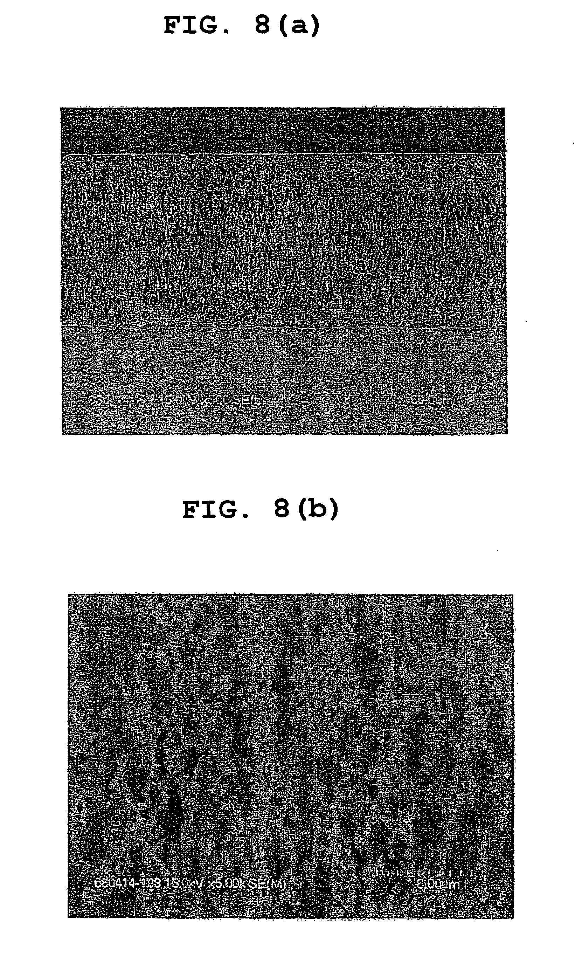

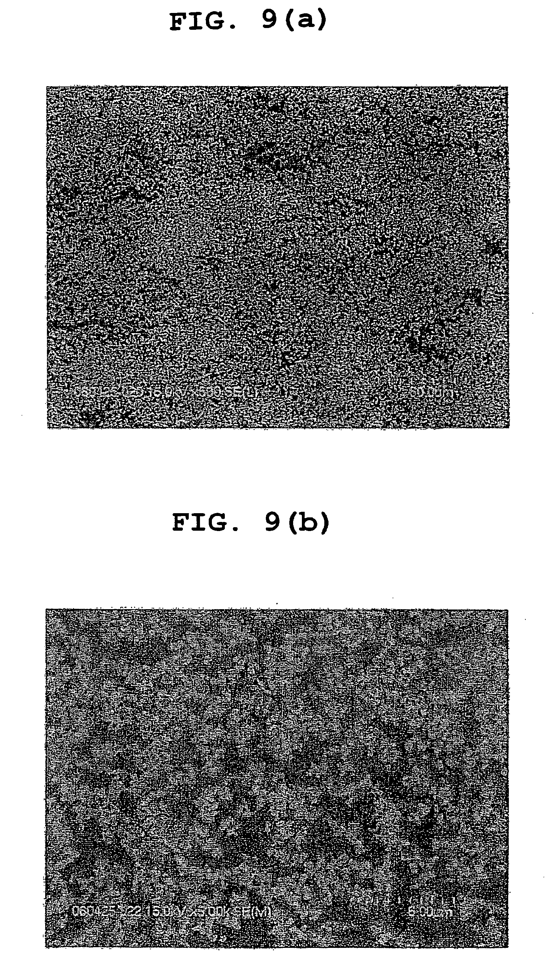

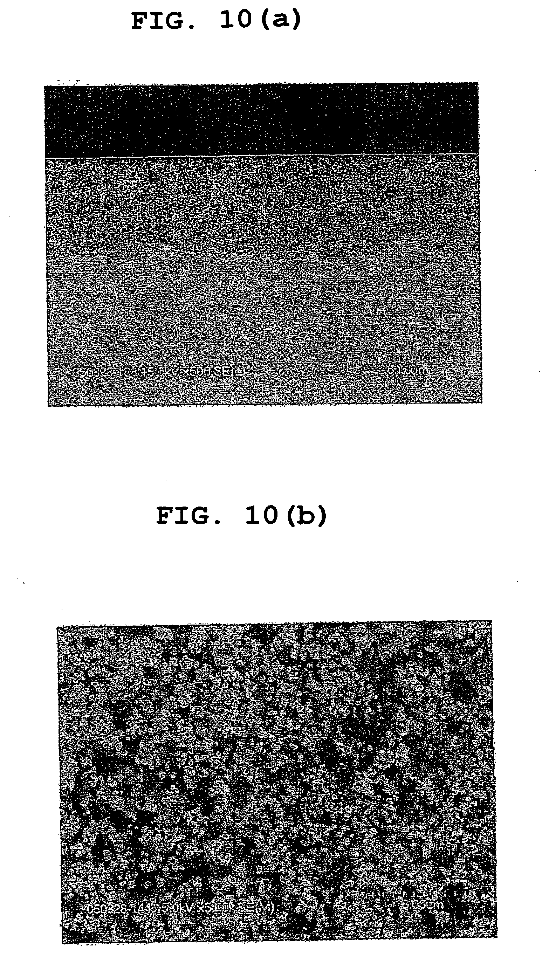

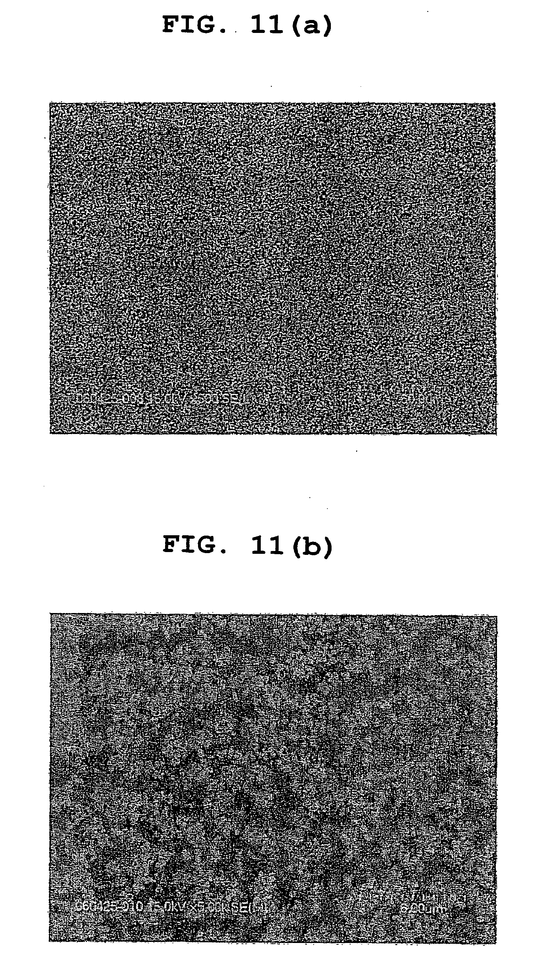

Fig. 7(a) is an SEM photograph of the section in the Ia-Ia direction of the composite material sheet obtained in Example 2, and Fig. 7(b) is an optical microscopic photograph of the section in the Ia-Ia direction of the composite material sheet obtained in Example 3. Fig. 8(a) shows an SEM photograph of Ia-Ia direction section in the composite material sheet obtained in Example 4, and Fig. 8(b) is an enlarged photograph of the center of the section. Moreover, Fig. 9(a) is an SEM photograph of the section in the Ib-Ib direction of the composite material sheet obtained in Example 4 and Fig. 9(b) is an enlarged photograph of the center of the section. Fig. 10(a) is an SEM photograph of the section in the Ia-Ia direction of the composite material sheet obtained in Comparative Example 4 and Fig. 10(b) is an enlarged photograph of the center of the section. Fig. 11(a) is an SEM photograph of the section in the Ib-Ib direction of the composite material sheet obtained in Comparative Example and Fig. 11(b) is an enlarged photograph of the center of the section.

From the optical microscopic photographs in the Ia-Ia direction (thickness direction) of the composite material sheets, it was confirmed that the filler formed dendritic aggregates in the Examples, which were uniformly oriented in the thickness direction, and in the Comparative Examples, many massive filler aggregates were observed, which were non-uniform and unoriented. From the SEM photographs in the Ib-Ib direction (xy direction) of the composite material sheets, it was confirmed that the composite material sheets in the Examples formed dense and non-dense distribution states of the fillers and the fillers formed dendritic aggregates in the dense parts. It is assumed that such filler distribution contributes to the expression of high dielectric property.

**Table 5**

| | dielectric property (1 kHz) | | degree of orientation | water content (wt%) |
|---|---|---|---|---|
| | dielectric constant | dielectric tangent | | |
| Example 1 | 10.1 | 0.038 | 1.412 | 0.03 |
| Example 2 | 15.8 | 0.043 | 1.377 | |
| Example 3 | 21.5 | 0.033 | 1.200 | |
| Example 4 | 28.9 | 0.035 | 1.305 | |
| Example 5 | 38.0 | 0.023 | 1.745 | |
| Example 6 | | | 1.35 | |
| Example 7 | | | 1.33 | |
| Comparative Example 1 | 3.3 | 0.034 | | 0.27 |
| Comparative Example 2 | 4.2 | 0.020 | 1.032 | |
| Comparative Example 3 | 5.5 | 0.019 | 1.026 | |
| Comparative Example 4 | 10.5 | 0.023 | 1.038 | |
| Comparative Example 5 | 18.1 | 0.022 | 1.045 | |
| Comparative Example 8 | 4.1 | 0.035 | 1.027 | 0.36 |
| Comparative Example 9 | 5.6 | 0.041 | 1.033 | |
| Comparative Example 10 | 10.7 | 0.033 | 1.024 | |
| Comparative Example 11 | 18.3 | 0.028 | 1.035 | |

### (3) Thermal conductivity

The composite material sheets obtained in Example 6 and Comparative Example 6 were measured for thermal conductivity according to ASTM E1530. As a result, the thermal conductivity of the composite material sheet of Example 6 was 2.5 W/mk, whereas that of the composite material sheet of Comparative Example 6 was 1.8 W/mk. From the result, the composite material sheet of the Example was confirmed to be superior in thermal conductivity. The thermal conductivity was measured according to the laser flash measurement method using a thermal constant measurement apparatus (model TC-7000, manufactured by ULVAC-RIKO, Inc.).

### (4) Volume resistivity

The composite material sheets obtained in Example 7 and Comparative Example 7 were measured for volume resistivity according to JIS K7194. As a result, the volume resistivity of the composite material sheet of Example 7 was 5.7×10¹² Ω·cm, whereas that of the composite material sheet of Comparative Example 7 was 8.3×10¹² Ω·cm. From the result, the composite material sheet of the Example was confirmed to be superior in conductivity. The volume resistivity was measured using a minute ammeter (model TR-8641, manufactured by Takeda Riken Kogyo K. K.), a DC power source (model PLE-650-0.1, manufactured by Matsusada Precision Inc.), and a voltmeter (model R6452A, manufactured by ADVANTEST CORPORATION).

## Claims

1. A composite material sheet comprising a filler and an organic resin matrix, wherein the filler is aggregated dendritically and oriented in the thickness direction in the organic resin matrix.

2. The composite material sheet of claim 1, wherein the degree of orientation of the filler is greater than 1.05.

3. The composite material sheet of claim 1 or 2, wherein the filler has a higher dielectric constant than that of the organic resin.

4. The composite material sheet of any one of claims 1 to 3, wherein the filler is at least one kind of an inorganic particle and an inorganic fiber.

5. The composite material sheet of any one of claims 1 to 4, wherein the content of the filler is 5 - 60% by volume relative to the organic resin.

6. A dielectric sheet comprising the composite material sheet of any one of claims 1 to 5 and at least one kind from a dielectric inorganic particle and a dielectric inorganic fiber as the filler.

7. A thermally conductive sheet comprising the composite material sheet of any one of claims 1 to 5 and at least one kind from a thermally conductive inorganic particle and a thermally conductive inorganic fiber as the filler.

8. An anisotropic conductive sheet comprising the composite material sheet of any one of claims 1 to 5 and at least one kind from a conductive inorganic particle and a conductive inorganic fiber as the filler.

9. A method of producing a composite material sheet wherein a filler is oriented in a given direction in an organic resin matrix, which comprises a kneading step comprising kneading an organic resin and a filler without using an organic solvent to give a composite material having a water content of not more than 0.30 wt%, wherein the filler is dispersed in the organic resin matrix, an electric field treatment step comprising applying the composite material to an electrode, or injecting or placing the composite material between the electrodes, and applying an alternating voltage to orient the filler in a given direction, and a fixing step to fix the oriented filler in the organic resin matrix.

10. A method of producing a composite material sheet wherein a filler is oriented in a given direction in an organic resin matrix, which comprises a kneading step comprising kneading an organic resin and a filler without using an organic solvent to give a composite material having a water content of not more than 0.30 wt%, wherein the filler is dispersed in the organic resin matrix, an electric field treatment step comprising coating the composite material with a resin film, and applying an alternating voltage to orient the filler in a given direction, and a fixing step to fix the oriented filler in the organic resin matrix.

11. The production method of claim 9 or 10, wherein, in the electric field treatment step, the filler is oriented in the thickness direction as a dendritic aggregate.

12. The production method of any one of claims 9 to 11, wherein the filler has a higher dielectric constant than that of the organic resin.

13. The production method of any one of claims 9 to 12, wherein the filler is at least one kind of an inorganic particle and an inorganic fiber.

14. The production method of any one of claims 9 to 13, wherein, in the kneading step, the composite material is prepared using a filler having an average particle size of not less than 1 µm and an organic resin that makes the ratio (A/B) of the dielectric constant (A) of the filler and the dielectric constant (B) of the organic resin not less than 10 and, in the electric field treatment step, an alternating voltage having an electric field strength of not less than 0.1 kV/mm is applied to the composite material.

15. The production method of any one of claims 9 to 13, wherein, in the kneading step, the composite material is prepared using a filler having an average particle size of not less than 1 µm and an organic resin that makes the ratio (A/B) of the dielectric constant (A) of the filler and the dielectric constant (B) of the organic resin less than 10 and, in the electric field treatment step, an alternating voltage having an electric field strength of not less than 1 kV/mm is applied to the composite material.

16. The production method of any one of claims 9 to 13, wherein, in the kneading step, the composite material is prepared using a filler having an average particle size of less than 1 µm and an organic resin that makes the ratio (A/B) of the dielectric constant (A) of the filler and the dielectric constant (B) of the organic resin not less than 10 and, in the electric field treatment step, an alternating voltage having an electric field strength of not less than 1 kV/mm is applied to the composite material.

17. The production method of any one of claims 9 to 13, wherein, in the kneading step, the composite material is prepared using a filler having an average particle size of less than 1 µm and an organic resin that makes the ratio (A/B) of the dielectric constant (A) of the filler and the dielectric constant (B) of the organic resin less than 10 and, in the electric field treatment step, an alternating voltage having an electric field strength of not less than 10 kV/mm is applied to the composite material.
